# EUROPEAN PATENT APPLICATION

(11) **EP 3 422 420 A1**
(43) Date of publication of application: **02.01.2019**
(21) Application number: 17897226.1
(22) Date of filing: 13.09.2017
(51) Int. Cl.: H01L 31/0443, H01L 31/05, H01L 31/18

(54) **VEHICLE ROOF SOLAR CHIP INTEGRATED DEVICE, SOLAR CAR, AND CHIP PACKAGING METHOD**

(30) Priority: 22.03.2017 CN 201710175398
(71) Applicant: Dong Han New Energy Automotive Technology Co., Ltd, 201801 Shanghai (CN)
(72) Inventor: MING, Qiaohong, Shanghai 201801 (CN); GAO, Weimin, Shanghai 201801 (CN); XU, Kangcong, Shanghai 201801 (CN); XIAO, Hansong, Shanghai 201801 (CN); YAN, Ting, Shanghai 201801 (CN); GUO, Guangxi, Shanghai 201801 (CN); YU, Xiang, Shanghai 201801 (CN); ZHOU, Wei, Shanghai 201801 (CN)
(74) Representative: Roman, Alexis
(86) International application number: PCT/CN2017/101482
(87) International publication number: WO 2018/171129

(57) **Abstract**

The present invention provides a roof-mounted solar module integration device, a solar power vehicle and a encapsulation method for modules. The integration device comprises: a substrate in which a through-hole is formed, wherein a front side of the substrate is provided with a first trench, and a reverse side of the substrate is provided with a second trench; a solar module fixed on the front side of the substrate; a plurality of conductive bands arranged in the first trench, wherein a first end of each of the conductive bands is connected with the solar module, and a second end is led out of the through-hole to the reverse side of the substrate; and a bypass diode and an anti-reversion diode which are arranged in the second trench and connected with the second ends of the conductive bands. According to the roof-mounted solar module integration device, the solar power vehicle and the encapsulation method for modules as provided by the present invention, the trenches and the through-hole are formed in the substrate to achieve the arrangement of the bypass diode, the anti-reversion diode and the conductive bands, which solves the problem in the prior art that electrical wiring control is not accurate, thereby increasing the amount of incident light of the solar module, simplifying the process, and improving the accuracy of electrical arrangement.

## Description

### Technical Field

The present invention relates to the technology of solar cells, and more particularly, to a roof-mounted solar module integration device, a solar power vehicle and a encapsulation method for modules.

### Background

As an important constituent part of the solar power vehicle, the solar module is used for converting light energy into electric energy, thereby providing power for the vehicle.To be prevented from being damaged, the solar module in the prior art is subjected to encapsulation. Currently, in most solar module encapsulation, protective materials (e.g., glass, organic glass, PC or plastic films) are spread and covered on the solar module surface in the manner of lamination. However, such a encapsulation manner has the following drawbacks:
1. The integration system with a solar module adds to the weight of the vehicle roof, which is detrimental to the vehicle's lightweight design;
2. The integration and construction operations for the electrical system of the solar module are faced with great difficulties;
3. As for diodes, conductive bands and electrical wire harnesses that are associated with the integration of the solar module, the accuracy of their arrangement positions is hard to control, and their construction is difficult;
4. As limited by the light transmittance of the encapsulation materials themselves, the encapsulation efficiency of the solar module is reduced;
5. As there are gaps between these encapsulation materials and the cell, the cell encapsulation effects would be affected by such external factors as water vapor, air and thermal expansion, such that sealability demands on encapsulation processes are extremely high.

### Summary of the Invention

The present embodiment to provide a roof-mounted solar module integration device, a solar power vehicle and a encapsulation method for modules to solve the problems existing in the prior art, thereby increasing the amount of incident light of the solar module, simplifying the process and improving the accuracy of electrical arrangement.

The present embodiment provides a roof-mounted solar module integration device, which comprises:
a substrate in which a through-hole is formed, wherein a front side of the substrate is provided with a first trench, and a reverse side of the substrate is provided with a second trench;
a solar module fixed on the front side of the substrate;
a plurality of conductive bands arranged in the first trench, wherein a first end of each of the conductive bands is connected with the solar module, and a second end is led out of the through-hole to the reverse side of the substrate; and
a bypass diode and an anti-reversion diode which are arranged in the second trench and connected with the second ends of the conductive bands.

As for the foregoing roof-mounted solar module integration device, optionally an inner wall of the through-hole is provided with an insulation layer.

As for the foregoing roof-mounted solar module integration device, optionally the solar module is a thin-film battery affixed on the front side of the substrate.

As for the foregoing roof-mounted solar module integration device, optionally the substrate is composed of upper and lower layers of glass fibers, with a layer of honeycomb-shaped fibers cladded therebetween.

As for the foregoing roof-mounted solar module integration device, optionally the solar module is provided thereon with a protective layer.

As for the foregoing roof-mounted solar module integration device, optionally the protective layer is a glass fiber protective layer entrained with epoxy resin.

As for the foregoing roof-mounted solar module integration device, optionally the protective layer is provided thereon with a masking paint, wherein the masking paint is disposed exactly opposite the through-hole.

The present invention also provides a solar power vehicle, wherein the vehicle comprises the roof-mounted solar module integration device provided by the present invention embodiment, and a plurality of substrates are spliced with one another to serve as the roof for the solar power vehicle.

The present invention further provides a encapsulation method for a solar module, which comprises the following steps:
step S100, forming a first trench in the front side of the substrate, forming a second trench in the reverse side of the substrate, and forming a through-hole in the substrate;
step S200, arranging conductive bands in the first trench, and arranging a bypass diode and an anti-reversion diode in the second trench;
step S300, fixing the solar module on the substrate, connecting the first ends of the conductive bands to the solar module, and leading the second ends of the conductive bands out of the through-hole to the reverse side of the substrate;
step S400, laying a protective layer on the solar module; and
step S500, providing a masking paint on the protective layer.

As for the foregoing encapsulation method, optionally the step S100 further comprises a step S110 of performing insulation for the through-hole.

As for the foregoing encapsulation method, optionally the step S500 is followed by:
step S600, vacuumization for between the solar module and the protective layer.

According to the roof-mounted solar module integration device, the solar power vehicle and the encapsulation method for modules as provided by the present invention, the trenches and the through-hole are formed in the substrate to achieve the arrangement of bypass diodes, anti-reversion diodes and conductive bands, which solves the problem in the prior art that electrical wiring control is not accurate, thereby increasing the amount of incident light of the solar module, simplifying the process, and improving the accuracy of electrical arrangement.

### Brief Description of the Drawings

Figure 1 is a main cross-sectional view illustrating a roof-mounted solar module integration device provided by an embodiment of the present invention;
Figure 2 is a schematic diagram illustrating a wire-leading state of a bypass diode in a second trench;
Figure 3 is a structural schematic diagram illustrating a solar module;
Figure 4 is an electrical schematic diagram illustrating the roof-mounted solar module integration device provided by the embodiment of the present invention;
Figure 5 is an electrical schematic diagram illustrating another roof-mounted solar module integration device provided by the embodiment of the present invention.

Reference numerals are illustrated as follows:
1-substrate; 11-through-hole; 2-solar module; 3-conductive band; 4-bypass diode; 5-protective layer; 6-masking paint; 7-positive electrode; 8-negative electrode; 9-connecting end; 10-anti-reversion diode; 12-MPPT.

### Detailed Description of the Invention

The embodiments of the present invention will now be described below in detail, and their examples are illustrated in the accompanying drawings, in which identical or similar reference numerals denote identical or similar elements or elements having identical or similar functions throughout the views. The embodiments described below with reference to the accompanying drawings are exemplary, which are merely used for explaining the present invention, and not intended to be interpreted as limitations on the present invention.

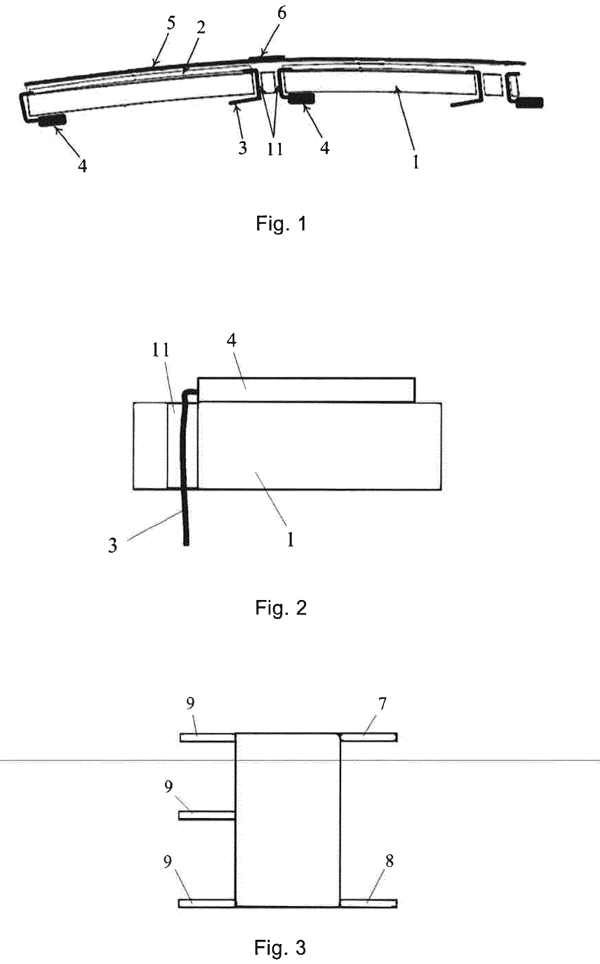

Figure 1 is a main cross-sectional view illustrating a roof-mounted solar module integration device provided by an embodiment of the present invention. The embodiment of the present invention provides a roof-mounted solar module integration device comprising a substrate 1, a solar module 2, a plurality of conductive bands 3, a bypass diode 4 and an anti-reversion diode.
wherein a plurality of substrates 1 are spliced with one another to serve as the roof for the solar power vehicle. The substrate 1 is provided therein with a through-hole 11, wherein a front side of the substrate 1 is provided with a first trench, and a reverse side of the substrate 1 is provided with a second trench. The solar module 2 is fixed on the front side of the substrate; the plurality of conductive bands 3 are arranged in the first trench, wherein a first end of each of the conductive bands 3 is connected with the solar module 2, and a second end is led out of the through-hole 11 to the reverse side of the substrate 1; and both the bypass diode 4 and the anti-reversion diode are arranged in the second trench and connected with the second ends of the conductive bands 3.

Figure 2 is a schematic diagram illustrating a wire-leading state of a bypass diode in a second trench. Referring to Figure 2, a conductive band 3 is led out from a through-hole 11 to be connected with a bypass diode 4.

As for the positioning and routing of the first and second trenches, they can be achieved accurately using precision equipment, thereby facilitating the arrangement and positioning of related components on the vehicle roof. The conductive bands, the bypass diode and the anti-reversion diode all extend to the reverse side of the substrate through the through-hole, which not only facilitates the connection of wire harnesses, but also ensures the flatness of the encapsulation surface for the solar module. In order to ensure the insulation between the through-hole and the conductive wires, optionally an inner wall of the through-hole is provided with an insulation layer. Optionally, the solar module 2 is a thin-film battery affixed on the front side of the substrate 1. Figure 3 is a structural schematic diagram illustrating a solar module. As shown in Figure 3, the solar module is provided with a positive electrode 7 and a negative electrode 8 as well as connecting ends 9 for connecting with bypass diodes 4 (or anti-reversion diodes). The bypass diodes 4 (or anti-reversion diodes) are connected respectively with the positive electrode 7 and the negative electrode 8 of the solar module 2 via conductive bands 3, which, after convergence, are led out from the reverse side of the substrate 1 to be connected with an MPPT.

The substrate 1 may be composed of upper and lower layers of glass fibers, with a layer of honeycomb-shaped fibers cladded therebetween. In this manner, the substrate is light in weight, and its strength is ensured, which is advantageous to the lightweight design for the vehicle body. As will be appreciated by those skilled in the art, the "front side" of the substrate involved in this embodiment refers to the side facing towards the sunlight, and the "reverse side" refers to the side facing away from the sunlight.

Optionally, the solar module 2 is provided thereon with a protective layer 5, thereby reaching the protective effects on the solar module 2. This protective layer 5 is optionally to be a glass fiber protective layer entrained with epoxy resin, and it may also be other materials, provided that they can protect the solar module 2 without affecting its light transmittance.

As shown in Figure 1, the above protective layer 5 is also optionally provided thereon with a masking paint 6, and the masking paint 6 is disposed exactly opposite the through-hole 11. After substrates 1 are spliced with one another, there would be gaps between substrates. Therefore, the masking paint 6 is provided so as to cover these gaps. The color of the masking paint 6 can be selected based on that of the solar module.

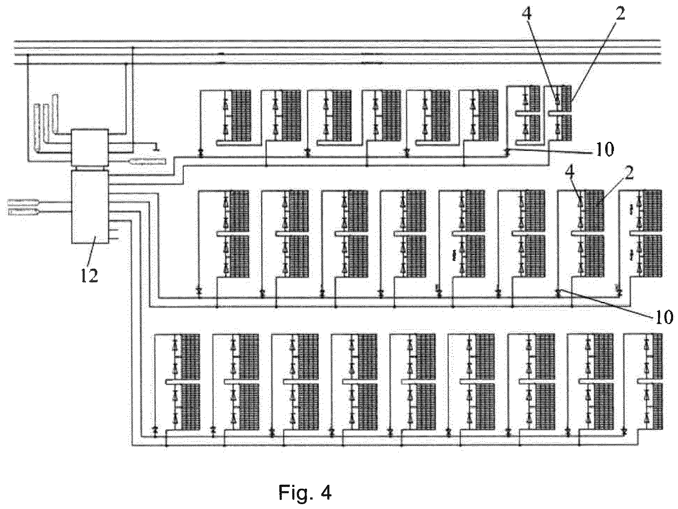

Figure 4 is an electrical schematic diagram illustrating the roof-mounted solar module integration device provided by the embodiment of the present invention. As shown in Figure 4, each solar module 2 is controlled via an independent bypass diode 4, and four solar modules 2 are connected in series to form an array, wherein an anti-reversion diode 10 is connected between two ends of the array. When an individual solar module is subjected to the hot spot effect and cannot generate electricity, the bypass diode 4 functions as a bypass to enable electric currents generated by other solar modules to flow therefrom and direct them into an MPPT 12. In this manner, the solar electricity-generating system can proceed with electricity generation, and the circumstance that electricity-generating circuits are blocked up due to the mulfunction of a certain solar module is avoided.

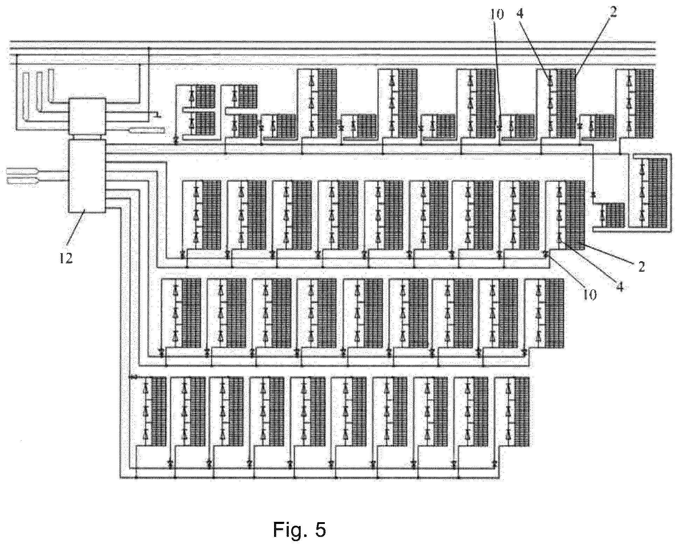

One of the functions of the anti-reversion diode is to avoid the problem that when a solar module or an array does not generate electricity, electric currents from cells would be delivered thereto in an reverse manner. In such case, energy would be consumed, and the solar module or array would be heated up or even damaged; another function of the anti-reversion diode is to avoid reverse delivery of electric currents among various branch circuits in the array. The problem of reverse delivery of electric currents may be attributable to the following causes: output voltages from various branch circuits connected in series cannot be absolutely equal, such that some of them might be high, while others might be low: alternatively, if a certain branch circuit is at fault or shaded, its output voltage would be reduced; in this case, electric currents from high-voltage branch circuits would be directed to low-voltage ones, and what's even more serious is that the overall output voltage of the array would be reduced. Nevertheless, such a phenomenon can be avoided by means of series connection of anti-reversion diodes with various branch circuits. Figure 5 is an electrical schematic diagram illustrating another roof-mounted solar module integration device provided by the embodiment of the present invention. As shown in Figure 5, each solar module 2 is controlled via an independent bypass diode 4, and four solar modules are connected in series to form an array, wherein an anti-reversion diode 10 is connected between two ends of the array. The MPPT 12 has four sets of input ends in total, and the uppermost set of input ends is connected with a plurality of arrays. Each array is formed by series connection of four solar modules 2, and an anti-reversion diode 10 is connected between two ends of this array. As for the arrays connected with the remaining three sets of input ends, each of them is formed by series connection of three solar modules 2, and an anti-reversion diode 10 is connected between two ends of each array.

Embodiments of the present invention also provide a solar power vehicle, wherein the vehicle comprises the roof-mounted solar module integration device provided by any embodiment of the present invention, and a plurality of substrates are spliced with one another to serve as the roof for the solar power vehicle.

The embodiments of the present invention further provide a encapsulation method for a solar module, which comprises the following steps:
step S100, forming a first trench in the front side of the substrate, forming a second trench in the reverse side of the substrate, and forming a through-hole in the substrate,
wherein this step also optionally comprises:
step S110, performing insulation for the through-hole;
step S200, arranging conductive bands in the first trench, and arranging a bypass diode and an anti-reversion diode in the second trench;
step S300, fixing the solar module on the substrate, connecting the first ends of the conductive bands to the solar module, and leading the second ends of the conductive bands out of the through-hole to the reverse side of the substrate;
step S400, laying a protective layer on the solar module, such that the encapsulation surface of the solar module is featured by watertightness, scratch prevention, resistance to chemical corrosion and easy cleaning; and
step S500, providing a masking paint on the protective layer.

After the step S500, the encapsulation method also comprises:
step S600, performing vacuumization for a gap between the solar module and the protective layer so as to ensure that there are not any gaps between the encapsulation material and the solar module, the encapsulation material has a high light transmittance, the encapsulation efficiency is high, and sealing effects are good.

The roof-mounted solar module integration device, the solar power vehicle and the encapsulation method for modules as provided by the embodiments of the present invention have the following advantages:
1. Substrates are directly used as the roof structure upon their splicing, which is advantageous to the lightweight design for the vehicle body; further, the substrate employs a encapsulation base formed by lamination of glass fibers and honeycomb-shaped fibers, which has not only good strength, but also light weight, thus facilitating the lightweight design for the vehicle body;
2. With a separate vehicle roof, operation and construction are convenient; specifically, all the solar modules are packaged offline prior to their installation in the vehicle body, which facilitates precise positioning and assists drilling equipment in accurate positioning, and can achieve batch-type line production;
3. Bypass diodes and wire harnesses are installed and arranged offline, which renders operation easier, and can readily achieve standardized production;
4. During encapsulation, the surface of the solar module is almost free of uneven force; moreover, upon encapsulation, the surface of the cell wouldn't be subjected to external force, and thus, the solar module is less susceptible to damage;
5. There are not any gaps between the encapsulation material and the solar module, the encapsulation material has a high light transmittance, the encapsulation efficiency is high, and sealing effects are good;
6. The encapsulation surface is featured by watertightness, scratch prevention, resistance to chemical corrosion and easy cleaning.

The configuration, features and effects of the present invention have been described in detail in the above embodiments illustrated in conjunction with the drawings. What have been described above are merely preferred embodiments of the present invention, but the implementation range of the present invention is not limited to the illustration of the drawings. All the variations or equally effective embodiments amended as equivalent modifications, which are made based on the idea of the present invention without departing from the spirit covered by the description and the accompanying drawings, shall fall into the scope of protection of the present invention.

## Claims

1. A roof-mounted solar module integration device, **characterized by** comprising:
a substrate (1) in which a through-hole (11) is formed, wherein a front side of the substrate (1) is provided with a first trench, and a reverse side of the substrate (1) is provided with a second trench;
a solar module (2) fixed on the front side of the substrate (1);
a plurality of conductive bands (3) arranged in the first trench, wherein a first end of each of the conductive bands (3) is connected with the solar module (2), and a second end is led out of the through-hole (11) to the reverse side of the substrate (1); and
a bypass diode (4) and a reverse-flow preventing diode which are arranged in the second trench and connected with the second ends of the conductive bands (3).

2. The roof-mounted solar module integration device of claim 1, **characterized in that** an inner wall of the through-hole (11) is provided with an insulation layer.

3. The roof-mounted solar module integration device of claim 1, **characterized in that** the solar module (2) is a thin-film cells affixed on the front side of the substrate (1).

4. The roof-mounted solar module integration device of any one of claims 1-3, **characterized in that** the substrate (1) is composed of upper and lower layers of glass fibers, with a layer of honeycomb-shaped fibers formed therebetween.

5. The roof-mounted solar module integration device of claim 4, **characterized in that** the solar module (2) is provided thereon with a protective layer (5).

6. The roof-mounted solar module integration device of claim 5, **characterized in that** the protective layer (5) is a glass fiber protective layer entrained with epoxy resin.

7. The roof-mounted solar module integration device of claim 6, **characterized in that** the protective layer (5) is provided thereon with a masking paint (6), wherein the masking paint (6) is disposed exactly opposite the through-hole (11).e

8. A solar power vehicle, **characterized by** comprising the roof-mounted solar module integration device of any one of claims 1-7, wherein a plurality of substrate (1)s are spliced with one another to serve as a roof for the solar power vehicle.

9. A encapsulation method for a solar module (2), **characterized by** comprising the following steps:
Step S100, forming a first trench in a front side of a substrate (1), forming a second trench in a reverse side of the substrate (1), and forming a through-hole (11) in the substrate (1);
Step S200,arranging conductive bands (3) in the first trench, and arranging a bypass diode (4) and
a reverse-flow preventing diode in the second trench;
Step S300, fixing the solar module (2) on the substrate (1), connecting first ends of the conductive bands (3) to the solar module (2), and leading second ends of the conductive bands (3) out of the through-hole (11) to the reverse side of the substrate (1);
Step S400, laying a protective layer (5) on the solar module (2); and
Step S500,providing a masking paint (6) on the protective layer (5).

10. The encapsulation method of claim 9, **characterized in that** the step S100 further comprises Step S110, performing insulation for the through-hole (11).

11. The encapsulation method of claim 9 or 10, **characterized in that** the step S500 is followed by:
Step S600, performing vacuumization for a gap between the solar module (2) and the protective layer (5).
